Europäisches Patentamt

European Patent Office

Office européen des brevets

(11) Publication number: 0 376 897 A1

## (12) EUROPEAN PATENT APPLICATION

(21) Application number: 89830510.7

(22) Date of filing: 21.11.89

(51) Int. Cl.5: G01R 19/175, H03K 5/153, G01D 5/244

(30) Priority: 25.11.88 IT 6805888

(43) Date of publication of application:
04.07.90 Bulletin 90/27

(84) Designated Contracting States:
AT BE CH DE ES FR GB GR IT LI LU NL SE

(71) Applicant: MARELLI AUTRONICA S.p.A.
Piazza Sant'Ambrogio, 6
I-20123 Milano(IT)

(72) Inventor: Cianci, Cesario
Via Martin Luther King 5
I-10044 Pianezza (Torion)(IT)
Inventor: Ciliberto, Luigi
Via Lancia 138/10
I-10141 Torino(IT)

(74) Representative: Quinterno, Giuseppe et al
c/o Jacobacci-Casetta & Perani S.p.A. Via
Alfieri, 17
I-10121 Torino(IT)

(54) A circuit for processing the signal generated by a variable-reluctance electromagnetic rotation sensor.

(57) The circuit comprises a first threshold comparator (A) with hysteresis arranged to provide a reference signal ($V_1$) indicative of the zero-crossing of the sensor signal ($V_p$). Also connected to the sensor (1,W,P) is an integrator circuit (B) whose output is connected to the input of a second threshold comparator (C). The latter provides an enabling output ($V_2$) signal only when the integrated signal ($V_i$) remains above a reference signal ($S_2$). A logic circuit (D) is connected to the two threshold comparators (A,C) and transmits the output reference signal ($V_1$) provided by the first comparator (A) only when the second comparator (C) outputs the enabling signal ($V_2$). Immediately after the first comparator (A) has transmitted this reference signal ($V_1$) to the logic circuit (D), the logic circuit (D) is disabled. This can conveniently be achieved by the stopping of the operation of the integrator (B). The time window during which the logic circuit (D) is enabled is thus reduced and the danger that the logic circuit (D) may transmit spurious output signals generated as a result of interference picked up is consequently reduced.

FIG. 1

## A circuit for processing the signal generated by a variable-reluctance electromagnetic rotation sensor

The present invention relates to a circuit for processing the signal generated by a variable-reluctance electromagnetic rotation sensor.

The invention relates in particular to a circuit comprising:

first threshold comparator means for comparing the signal provided by the sensor with a first threshold level and providing a reference output signal indicative of the zero-crossing of the signal,

an integrator circuit which is likewise intended to be connected to the sensor,

second comparator means for providing an enabling signal when the signal provided by the integrator exceeds a second threshold level, and

a logic circuit which has first and second inputs connected to the outputs of the first and second comparator means respectively and is arranged to transmit the output reference signal indicative of the zero-crossing of the sensor signal only when the second comparator means provide the enabling signal.

A circuit for processing the signal generated by a variable-reluctance electromagnetic rotation sensor of this type is described, for example, in the previous European patent application published with the number 0166699 in the name of the same Applicant. In this known circuit, the logic circuit is kept "open" throughout the time during which the integrated signal remains above the threshold of the second comparator means. The time window during which the logic circuit is "open" normally extends well beyond the time at which the logic circuit transmits an output reference signal indicative of the zero-crossing of the sensor signal. This involves the potential danger that, after it has output the reference signal, and during the remaining portion of its "open" time window, the logic circuit may allow the passage of spurious signals whose level is greater than the threshold associated with the first comparator means, and which result from intereference picked up.

The object of the present invention is to produce a circuit of the type described above which enables the problem described above to be avoided.

According to the invention, this object is achieved by means of a circuit for processing the signal generated by a variable-reluctance electromagnetic rotation sensor of the type specified above, whose main characteristic lies in the fact that it also includes stopping means for disabling the logic circuit immediately after the first comparator means have transmitted to the logic circuit the reference signal indicative of the zero-crossing of the sensor signal.

According to a further characteristic of the invention, the stopping means are arranged to provide the integrator with a stopping signal for stopping the enabling signal output by the second comparator means.

Further characteristics and advantages of the present invention will become clear from the detailed description which follows with reference to the appended drawings, provided by way of non-limiting example, in which:

Figure 1 is a block diagram of a circuit according to the invention, and

Figure 2 is a series of graphs which show examples of traces of signals generated in the circuit of Figure 1.

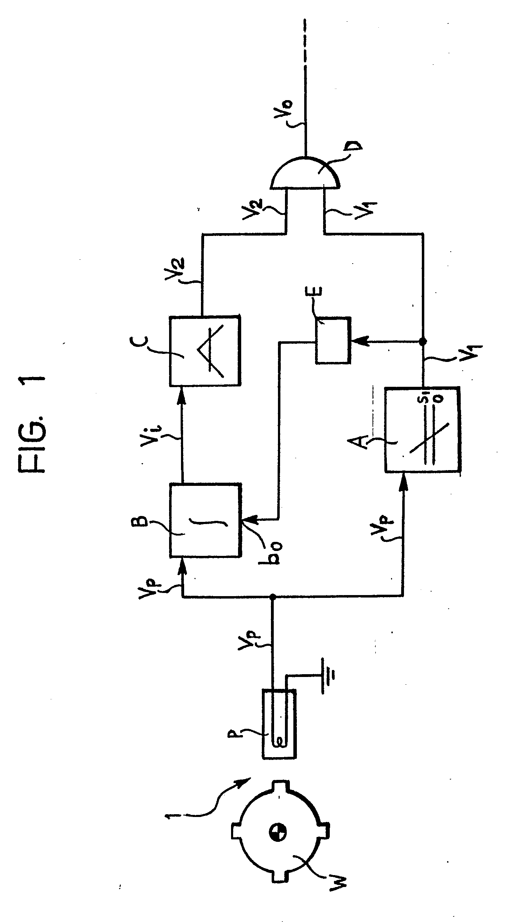

With reference to Figure 1, a variable-reluctance electromagnetic rotation sensor of the so-called phonic wheel type is generally indicated 1. In general, this comprises a toothed rotor W with which an inductive pick-up P is associated.

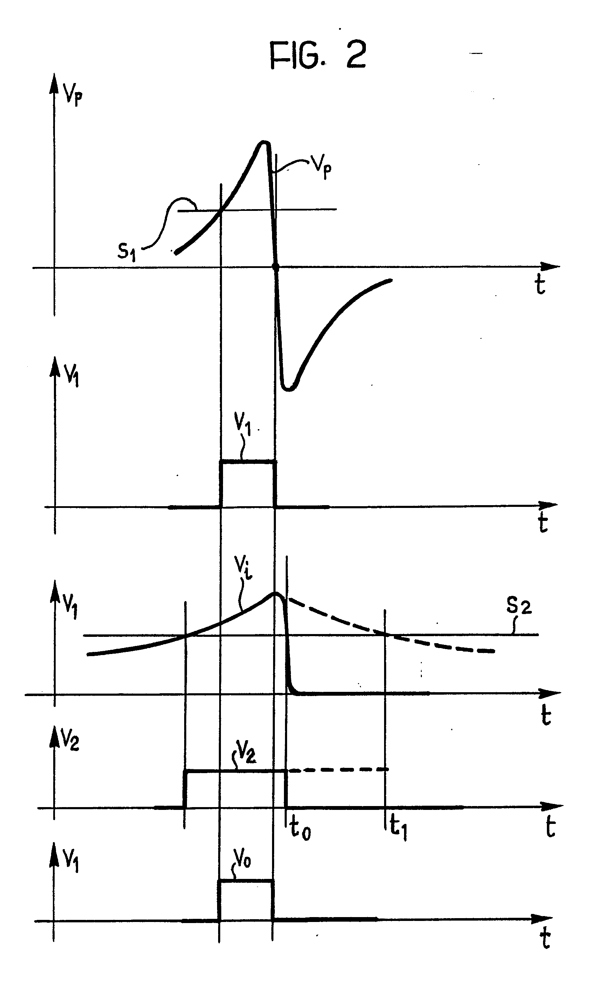

The inductive pick-up P is connected to the input of a first threshold comparator with hysteresis, indicated A. This comparator is arranged so that its output changes state (for example, switching from low level to high level) when the signal $V_p$ provided by the pick-up exceeds a positive threshold level $S_1$, as shown in Figure 2. In this figure, the signal output by the comparator A is indicated $V_1$.

The threshold level $S_1$ with which the signal $V_p$ is compared is conveniently a function of the amplitude of the same signal $V_p$, in known manner.

The comparator A is arranged to change stage again when the signal $V_p$ falls below zero. In the example illustrated with reference to Figure 2, the trailing edge of the signal $V_1$ is indicative of the zero-crossing of the signal $V_p$.

The pick-up P is also connected to the input of an integrator circuit, generally indicated B, produced, for example, with the use of an operational amplifier and a feedback capacitor. The signal $V_i$ output by the integrator B has a trace shown qualitatively in Figure 2, and is applied to the input of a second threshold comparator, indicated C. This comparator compares the signal $V_i$ with a threshold level $S_2$ and outputs a signal indicated $V_2$. In the example illustrated, this signal switches from low level to high level as soon as the integrated signal $V_i$ exceeds the threshold $S_2$.

The outputs of the threshold comparators A and C are connected to respective inputs of a logic circuit indicated D. In the example illustrated, this circuit is constituted by an AND logic gate.

The signal output by the logic circuit D is indicated $V_0$. With reference to Figure 2, the signal

$V_0$ switches to low level and to high level in correspondence with the crossing of the threshold $S_1$ by the signal $V_p$ and switches from high level to low level when the signal $V_p$ passes through zero.

A stopping circuit arranged between the output of the threshold comparator A and a disabling input $b_0$ of the integrator B is indicated E. Each time the signal $V_1$ has a trailing edge (that is, for each zero-crossing of the signal $V_p$), the stopping circuit E stops the integrator B by forcing its output to zero, causing the switching of the output of the comparator C and thus the "closure" of the logic gate D immediately after it has output the trailing edge of the signal $V_0$.

As a result of the operation of the stopping circuit E, the time window during which the logic gate D is open ends at the moment indicated $T_0$ in Figure 2, and therefore substantially in advance of the time $t_1$ at which it would end in the absence of the operation of the circuit E, as occurs in prior-art circuits.

The possibility is thus avoided of any pulsed interference which is picked up and has an amplitude greater than the threshold $S_1$ finding the gate D "open" and therefore being able to be interpreted erroneously as indicative of a further zero-crossing of the signal $V_p$ during the time interval elapsing between the moments indicated $t_0$ and $t_1$.

The circuit according to the invention is therefore clearly more reliable than those of the prior art.

## Claims

1. A circuit for processing the signal ($V_p$) generated by a variable-reluctance electromagnetic rotation sensor (1, W, P), comprising:
first threshold comparator means (A) for comparing the signal ($V_p$) provided by the sensor (1, W, P) with a first threshold level ($S_1$) and providing a reference output signal ($V_1$) indicative of the zero-crossing of the signal ($V_p$),
an integrator circuit (B) which is likewise intended to be connected to the sensor (1, W, P),
second threshold comparator means (C) for providing an enabling signal ($V_2$) when the signal ($V_i$) provided by the integrator (B) exceeds a second threshold level ($S_2$), and
a logic circuit (D) which has first and second inputs connected to the outputs of the first and second comparator means (A, C) respectively and is arranged to transmit the output reference signal ($V_1$, $V_0$) indicative of the zero-crossing of the sensor signal (1, W, P) only when the second comparator means (C) provide the enabling signal ($V_2$), characterised in that it also includes stopping means (E) for disabling the logic circuit (D) immediately after the first comparator means (A) have transmitted the reference signal ($V_1$) to the logic circuit (D).

2. A circuit according to Claim 1, characterised in that the stopping means (E) are arranged to provide the integrator (B) with a stopping signal for cancelling the signal ($V_i$) output by the integrator (B).

FIG. 1

# FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | EP-A-0 166 699  (MARELLI)<br>* Whole document *<br>--- | 1 | G 01 R   19/175<br>H 03 K    5/153<br>G 01 D    5/244 |
| A | US-A-3 944 936  (PRYOR)<br>* Abstract; figures *<br>--- | 1 | |
| A | US-A-3 753 109  (SCHAINBAUM)<br>* Abstract; figures *<br>----- | 1 | |

TECHNICAL FIELDS
SEARCHED (Int. Cl.5)

G 01 R
G 01 D
G 01 P
H 03 K

The present search report has been drawn up for all claims

| Place of search | Date of completion of the search | Examiner |
|---|---|---|
| THE HAGUE | 27-03-1990 | LLOYD P.A. |